# EUROPEAN PATENT SPECIFICATION

(11) **EP 0 285 445 B1**
(45) Date of publication and mention of the grant of the patent: **01.06.1994**
(21) Application number: 88302957.1
(22) Date of filing: 31.03.1988
(51) Int. Cl.: H01L 23/52, H01L 23/48, H01L 39/12, H01L 39/24, H01L 21/90

(54) **Electric circuit having superconducting multilayered structure and manufacturing method for same**
Elektrische Schaltung mit supraleitender Mehrschichtstruktur und Herstellungsverfahren dafür
Circuit électrique comprenant une structure supraconductrice à multicouche et son procédé de fabrication

(30) Priority: 01.04.1987 JP 81487/87; 01.02.1988 JP 22384/88
(43) Date of publication of application: 05.10.1988
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-Ku Tokyo 157 (JP)
(74) Representative: Milhench, Howard Leslie

(56) References cited:
- EP-A- 0 292 125
- DE-A- 3 810 494
- PATENT ABSTRACTS OF JAPAN, vol. 7, no. 182 (E-192)[1327], 11th August 1983; & JP-A-58 87 884 5-05-1983
- PATENT ABSTRACTS OF JAPAN, vol. 11, no. 33 (E-476)[2480], 30th January 1987; & JP-A-61 201 467
- PATENT ABSTRACTS OF JAPAN, vol. 9, no. 321 (E-367)[2044], 17th December 1985; & JP-A-60 154 613

## Description

This invention relates to an electric circuit having a superconducting structure.

Conventionally, a wire rod of Nb-Ge metallic material (for example, Nb₃Ge) has been used as a superconducting material. Superconducting magnets have been manufactured only with such conventional type of wire.

In addition, in recent years ceramic materials which exhibit superconducting properties have become known.

On the other hand, semiconductor devices provided with a plurality of elements containing semiconductor integrated circuits within the same substrate are known.

The development of more and more refined semiconductor integrated circuits with high speed action has in recent years become a necessity. However, along with these refinements problems have arisen in that reliability has suffered from the heat generated in the semiconductor element and also the operating speed of the heated parts has been reduced. For these reasons attention has been directed to the provision of improved circuit structures utilizing superconducting ceramics.

Disclosed in Patent Abstracts of Japan, Vol 7, No. 182 (E-192) (1327) August 11, 1983 for example is a proposal for forming a gold electrode on a superconducting thin film of BaPb₁₋ₓBiₓO₃ without deteriorating the superconductive characteristics of the superconductor. According to this proposal, gold is evaporated onto a superconductive thin film formed on a substrate and photolithographic techniques are employed for patterning the gold to obtain a desired electrode configuration. No patterning of the superconducting thin film is disclosed. Disclosed in EP-A-0 292 125, which is available under Article 54(3)EPC as a prior art citation against the novelty only of the present application, is a multilayer superconducting circuit substrate comprising insulating layers and interconnection patterns of an oxide superconductive material located between the insulating layers and interconnecting with each other via through holes in the insulating layers, the patterns of the superconductive ceramic material preferably being encapsulated with a noble metal such as gold, silver, platinum or alloys thereof. It is proposed in EP-A-0 292 125 that such a substrate may be used as a mounting for integrated circuits, etc.

According to the present invention there is provided an improved electric circuit comprising a thin film oxide superconductor formed on a substrate, characterized in that the thin film oxide superconductor comprises electrical circuit conductors formed of a superconductive oxide material, and an electrically insulating isolation layer of non-oxide material which does not interact or mix during firing with the superconductive oxide material is provided above and/or below the superconductive conductors covering and isolating the superconductive oxide material of the conductors from adjacent structure(s) of the circuit.

The foregoing and other features of the invention are set forth with particularity in the appended claims and will be explained fully in the following.

In accordance with one embodiment of the invention, the electrically insulating isolation layer comprises a carbon film formed in contact with the superconducting ceramic thin film. The carbon film is deposited on a substrate by decomposition of a carbon compound gas maintained, e.g., at 0.01 to 0.5 Torr (1 Torr = 133,32 Pa) by virtue of a plasma reaction supplied with DC or AC electric power. C-C and C=C bonds can be broken by high frequency power of 0.1 MHz to 50 MHz, e.g. 13.56 MHz. Further, C-H bonds can be broken by high frequency power of 1 GHz or higher. By this process, the carbon film becomes rich in C-C or -C-C- bonds with hybrid orbital PS³, and therefore becomes a diamond-like carbon having an energy gap of not lower than 1.0 eV, preferably 1.5 to 5.5 eV, rather than graphite which is opaque and cannot be used as a reliable insulating material. In accordance with other embodiments described hereinafter, the electrically insulating isolation layer comprises a nitride or carbide material such as silicon, aluminium or titanium nitride or silicon or titanium carbide.

In representative cases, superconducting ceramics for use in accordance with the present invention may be prepared consistent with the stoichiometric formula (A₁₋ₓBₓ)_{y}Cu_{z}0_{w}, where A is one or more elements of Groups IIIa, IIIb, Va and Vb of the Japanese Periodic Table, B is one or more elements of Group IIa of the Japanese Periodic Table, e.g. the alkaline earth metals including beryllium and magnesium, and 0.3≦ x <1; y=2.0-4.0; z=1.5-3.5, and w=4.0-10.0. Examples of this general formula are BiSrCaCu₂₋₃0₄₋₁₀, Y_{0.5}Bi_{0.5}Sr₁Ca₁Cu₂₋₃0₄₋₁₀, YBa₂Cu₃0₆₋₈, Bi₁Sr₁Mg_{0.5}Ca_{0.5}Cu₂₋₃0₄₋₁₀, Bi_{0.5}Al_{0.5}SrCaCu₂₋₃0₄₋₁₀. These materials can be formed on a surface by electron beam evaporation, sputtering, photoenhanced CVD, or photoenhanced PVD.

Hereinafter, the invention will be further explained by reference to a number of exemplary embodiments which are described in detail with reference to the accompanying drawings.

### BRIEF DESCRIPTION OF THE ACCOMPANYING DRAWINGS

Figs.1(A) to 1(D) are cross sectional views showing the manufacturing process of a first exemplary embodiment of the present invention;
Fig.2 is a cross sectional view showing a second exemplary embodiment of the present invention;
Fig.3 is a cross sectional view showing a manufacturing apparatus in accordance with the invention;
Figs.4(A) and 4(B) are cross sectional views showing the manufacturing process of a third exemplary embodiment of the present invention;
Fig.5 is a cross sectional view showing a fourth exemplary embodiment of the present invention; and

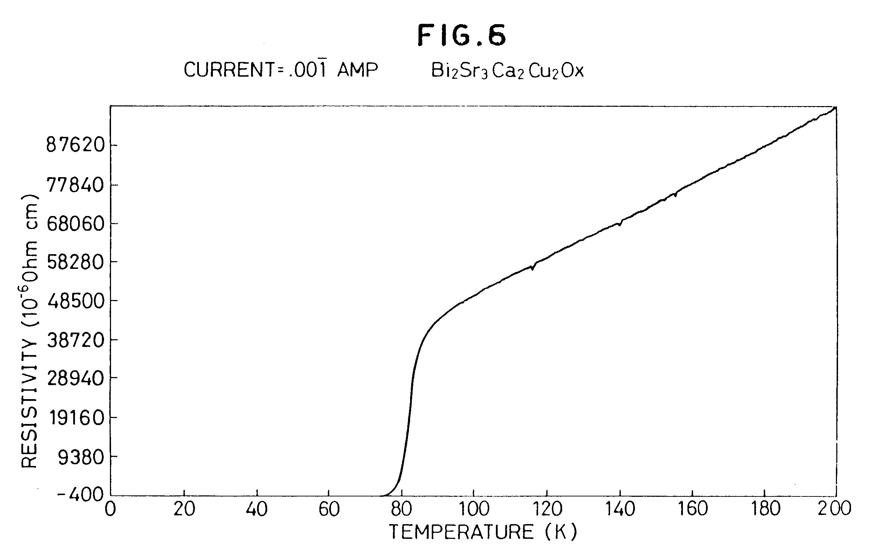

Figs.6 and 7 are graphical diagrams showing the relationship between the resistivity and the temperature of superconducting ceramics.

### DETAILED DESCRIPTION OF THE EMBODIMENTS

For the avoidance of doubt it is to be noted that all references herein and in the appended claims to the Periodic Table and to specific Groups of the Periodic Table are to be understood to refer to the Japanese notation of the Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European notations of the Periodic Table, Groups IIIa, IVa, Va, VIa and VIIa of the Japanese notation of the Periodic Table correspond respectively to Groups IIIb, IVb, Vb, VIb and VIIb of the European notation of the Periodic Table, and Groups IIIb, IVb, Vb, VIb and VIIb of the Japanese notation correspond respectively to Groups IIIa,, IVa, Va, VIa and VIIa of the European notation.

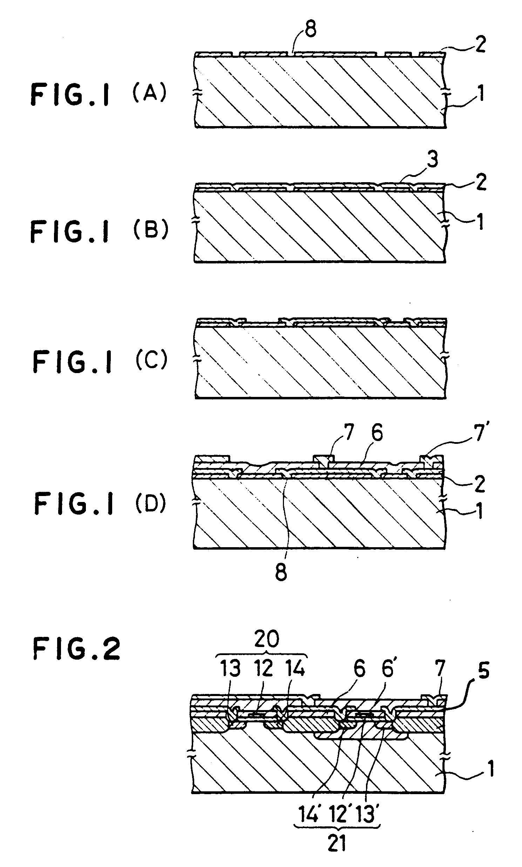

Referring to Figs.1(A) to 1(D), the steps in the production of a first exemplary embodiment of a semiconductor device in accordance with the present invention are shown.

The semiconductor device is comprised of a semiconductor substrate which is desirably heat resistant and might for example comprise mono-crystalline silicon and might have a plurality of elements such as insulated gate field effect transistors (IGFETs) formed therewithin. A superconducting ceramic material exhibiting zero electrical resistance is formed on the substrate or on the upper surface of an insulating film or conductor provided on the substrate, and the superconducting material is selectively etched and patterned utilizing photolithograpy. In addition, the crystalline structure of the superconducting ceramic material may be enhanced by heat annealing at 500-1000°C, particularly in an oxidizing atmosphere, either before or after photolithography so that superconductivity may be exhibited at extremely low temperatures. By depositing and photolithographically etching a plurality of superconducting layers, a plurality of interconnected circuit layers having conductors formed of a material exhibiting zero electrical resistance at a temperature lower than a certain critical level can be obtained.

Referring to Fig.1(A), an insulating film 2 is formed on a silicon semiconductor substrate 1 and openings 8 are formed in the insulating film 2 by photolithography. Within the semiconductor substrate 1, there are previously provided one or more insulated gate field effect transistors, active elements such as bipolar transistors or resistors and/or passive elements such as capacitors, for example, and contact sections for contacting electrodes of the active or passive elements are provided in registry with the openings 8.

The insulating film 2 may for example be made of a multilayer comprising an underlying silicon oxide film and an overlying silicon nitride film which provides the film 2 with a heat-resistant non-oxide upper surface. It is important that the material of the insulating film does not interact with or mix with the superconductor which is to cover it during firing. Instead of silicon nitride, other nitrides such as AℓN and TiN for example or carbon compounds such as SiC and TiC for example are also suitable as heat-resistant non-oxide materials. Within the insulating film 2 there are provided a number of contact areas at which the underlying substrate is exposed.

In Fig.1(B), a material which exhibits superconductivity is provided in the form of a thin film 3 on the upper surface of the insulating film 2. The thin film 3 is formed by sputtering in this embodiment, however the film 3 could alternatively be formed by screen printing, vacuum evaporation, or chemical vapour deposition (CVD) for example. The sputtering method is suitable for mass production, and easily produces a ceramic thin film which is heat resistant.

Examples of superconducting materials that can be used in the practice of the present invention are oxide ceramics consisting of elements of Groups IIIa and IIa of the Japanese notation of the Periodic Table and copper. When the film is formed by sputtering, the sputtering target may for example be made of a material conforming to the composition (Y₁₋ₓBaₓ)_{y}Cu_{z}0_{w}, where 0<x<1, y=2-4, z=1.5-3.5, w=4-10, such as (YBa₂)Cu₃0₆₋₈. Sputtering for this embodiment may for example be effected at a substrate temperature of 450°C, in an argon atmosphere, with an input power level of 100W at a frequency of 50Hz. The thin film of ceramic material in this case may be from 0.2 microns to 2 microns in thickness, and might for example have a thickness of 1 micron. The ceramic material may then be annealed under oxygen at about 700°C for about 10 hours. By this method it has been found possible to produce a superconducting thin film having a Tc onset temperature of 95°K. The resistivity begins to drop sharply below about 95°K, and experimentally we have found that the resistance was practically zero at 79°K.

Having deposited the superconducting film 3, in order to produce the electrodes and leads for the connecting wiring of the circuitry provided in the substrate and for connecting the electrodes of the elements to input and output terminals, the upper surface of the structure is photoresist coated in the required pattern configuration. Selective removal of the superconducting film is then performed by wet etching using acid, for example sulphuric or nitric acid, or by dry etching using CCl₄ or CBr₄ for example to obtain the semiconductor device of Fig.1(C). In this way, the prescribed patterning is carried out on the thin film 3 using photolithography. This patterning can be carried out just after the formation of the superconducting film, followed by heat annealing, so that only the patterned connecting operating sections will be selectively crystallized. By virtue of the fact that the crystal sizes are small even in the initial state of the superconducting layer, a smaller conductor size and pattern is possible in the connecting wiring which leads to higher speed of operation.

Fig.1(D) shows the required multilayered conductor pattern that is formed after the above process is carried out. Since metal has better connecting properties than the ceramic superconductor as regards connecting external leads to the semiconductor device, therefore, while the insulating film 6 between the layers is formed of a heat-resistant non-oxide insulating material such as silicon nitride or silicon carbide for example, the patterns 7 and 7' are preferably formed of a metal such as aluminium for example. Therefore, the one or more layers constituting the connecting wiring of the electronic circuit elements are formed from superconducting ceramic material, and the external electrodes of the assembly are preferably provided with metal pads for better bonding to other materials. Of course, the pad sections may also be made of superconducting material if the bonding capability of the superconducting material is sufficient for the purpose.

Fig.2 shows another embodiment of the present invention, specifically a C/MOS (complementary IGFET) section only. The section has a silicon semiconductor substrate 1 which provides adequate durability against damage during annealing of the superconductor. Further, a p-type well is formed within the substrate, and silicon oxide is provided thereon. One IGFET 20 is provided with a gate electrode 12, a source 13, and a drain 14 and constitutes a p-channel IGFET. Another IGFET is provided with a gate electrode 12', a source 13', and a drain 14', and constitutes an n-channel IGFET. The gate electrodes 12 and 12' are polycrystalline silicon, and the wiring connections between the gate electrodes 12 and 12' and the other wirings 7 are formed of superconducting material. This superconducting material may be made by a CVD method. In the case where no damage is caused to the lower substrate by so doing, the gate electrodes may be formed of superconducting material. As in the case of the foregoing embodiment, the insulating film 6 underlying the superconducting ceramic film and covering the gate electrode is made of a heat-resistant non-oxide insulating material such as silicon nitride or silicon carbide. The other insulating film 6' contacting the upper surface of the superconducting film 5 is also made of a heat-resistant non-oxide insulating film making contact with the other superconducting film 7.

When a semiconductor device as shown in Fig.2 is cooled to liquid nitrogen temperature, carrier mobility can be increased by a factor of 3 or 4. In addition, it becomes possible to reduce the electrical resistance of the lead wires and electrodes to zero. For this reason, extremely high speed device action becomes possible. It is also possible to provide a high temperature superconducting ceramic film of a thickness of 30 microns or less, e.g. 0.1 to 1 micron.

The semiconductor need not necessarily be made of silicon, but could be a semiconductor compound of GaAs obtained by heteroepitaxial growth on a silicon semiconductor for use as a semiconductor film. In this case, however, it is necessary to take steps to lower the annealing temperature so that the semiconductor substrate does not suffer damage by the heat applied during annealing of the superconductor.

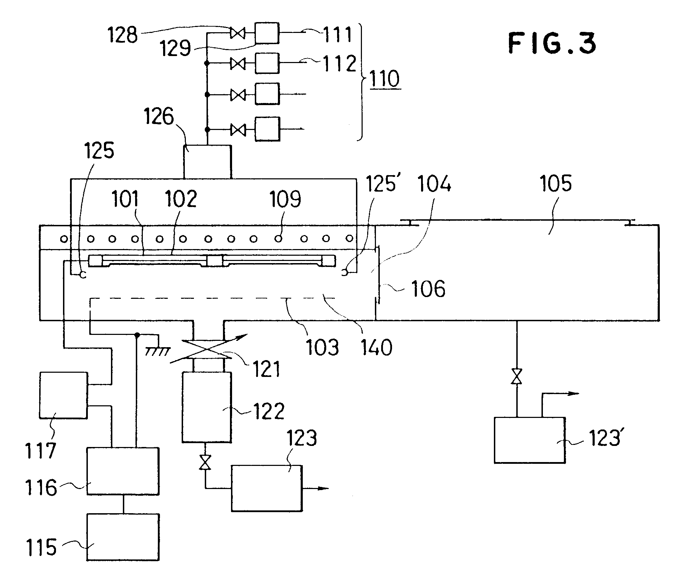

Hereinbelow, examples in which carbon films are in contact with superconducting ceramics are described. First, a process for depositing a carbon film on a substrate such as of glass, semiconductor or ceramic material for example will be described in conjunction with Fig.3. The substrate may be provided with a superconducting pattern and built-in semiconductor circuitry. In this description, although carbon deposition may be performed also in the form of clusters or in other forms instead of in film form, depending on the requirements, all the carbon depositions are simply called film for convenience hereinafter.

Fig.3 is a cross sectional schematic view showing a plasma enhanced chemical reaction apparatus which may be used in the deposition and etching operations. The apparatus comprises a reaction chamber 104, a loading-unloading chamber 105, a gas feeding system 110, a high frequency power source 115 associated with a matching transformer 116, a rotary pump 123 connected to the reaction chamber 104 through a turbo molecular pump 122 and valve 121, and a rotary pump 123' connected to the loading-unloading chamber 105. The reaction chamber 104 is provided with a heater 109 to maintain the substrate temperature at an appropriate level during the operating process.

Substrates 110 to be coated with carbon are transported from the loading chamber 104 to the reaction chamber 105 through a gate valve 106, each of the chambers being evacuated to a predetermined negative pressure in advance. After evacuating the reaction chamber 104 further if necessary with the gate valve closed, a carbon compound gas such as CH₄ or C₂H₄ and hydrogen gas are inputted to the reaction chamber 104 respectively from inlet ports 112 and 111 through flow meters 129, valves 128 and a microwave excitation means 126. The gas outlet is a pair of ports 125 and 125' between which there is located a substrate holder 102 functioning also as a first electrode. The flow rates of the carbon compound gas and hydrogen gas are equal and controlled so that the pressure of the reactive gas in the reaction chamber is maintained at 0.001 Torr to 10 Torr. preferably 0.01 Torr to 1 Torr, e.g. 0.1 Torr, during deposition. The substrate temperature is -100°C to +150°C. In this condition, high frequency electric power of 50W to 1KW is applied between the first electrode 102 and a counterpart second electrode 103 from the power source 115. The power is biased through a DC source 117 by -200V to +600V. The electric power to the reaction space corresponds substantially to a voltage application alternating between -400V to +400V, since in absence of the bias voltage a self-bias of -200V appears between the first electrode 102 and the second electrode 103 which is earthed. When the reactive gas (CH₄ + H₂, for example) is energized in advance of the entrance to the reaction space by microwave excitation caused by microwave energy (2.45 GHz) emitted by the excitation means 126, the deposition speed can be increased by a factor of 5. In the case of etching, the etching speed can be increased by a factor of 4 by the microwave excitation of the etchant gas in advance of its introduction to the reaction chamber 104.

By virtue of the electric power, which is equivalent to 0.03 to 3 W/cm², the reaction gas is put into a plasma state in the region 140 and a carbon film is deposited on the substrate 101 at a growth rate of 10⁻⁸ to 10⁻⁷ m/min (100-1000 Å/min). The Vickers hardness of the carbon film is not lower than 2000 Kg/mm² and its thermal conductivity is not lower than 2.5 W/cm deg, preferably 4.0 to 6.0 W/cm deg. The carbon film has a microcrystalline or amorphous structure containing a large number of C-C bonds. We call such a very hard amorphous carbon "diamond-like carbon" or DLC for short. Of course, diamond can be formed by adjusting the deposition condition.

According to experimental results, the growth rates obtained on substrates maintained at -50°C to 150°C were 10⁻⁸ - 2 x 10⁻⁸ m/min (100-200 Å/min) when CH4 was used as the carbon compound and a DC bias voltage of +100V to +300V was applied with no microwave excitation, and were 5 x 10⁻⁸ - 10⁻⁷ m/min (500-1000 Å/min) when CH₄ or C₂H₄ was used with microwave excitation. Only samples having a thermal conductivity not lower than 2.5 W/cm deg were acceptable. The non-utilized exhaust gas was removed by means of the turbo molecular pump 122 and the rotary pump 123.

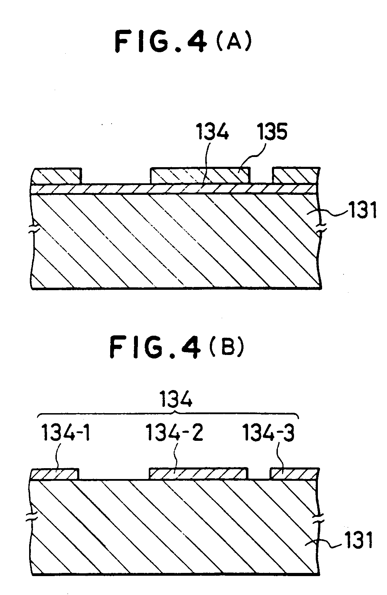

Next, an etching process for patterning a carbon film deposited as explained above will be described. In Fig.4(A), a mask 135 is formed on a carbon film 134 which is in turn deposited on a substrate 131. The mask may be made of insulating material such as silicon oxide, a photoresist, or silicon nitride. The substrate 131 is disposed in the reaction chamber 104 in the same way as for the deposition process explained supra. Then, oxygen is inputted from the inlet port 110 and 300 W high frequency power is inputted thereto with the pressure at 0.01 Torr to 1 Torr, e.g. 0.1 Torr. According to experimental results, the etching speed was measured to be 3.5 x 10⁻⁸ m/min (350 Å/min). The etching speed was decreased to 2.7 x 10⁻⁸ m/min (270 Å/min) when the pressure was 0.5 Torr. As a result, any portion of the carbon film 134 which is free of the mask 135 is removed by this etching. After removing the mask 135, a carbon pattern 134 comprising carbon layer portions 134-1, 134-2 and 134-3 is obtained as illustrated in Fig.4(B). Atmospheric air, N0₄, N0₂, N₂0, a mixture of oxygen and hydrogen and a gaseous oxide compound such as water may be used instead of oxygen in this process. Also, a fluorine compound gas can be used as the etchant gas, e.g. CF₄ or NF₃.

The chemical reaction apparatus of Fig.3 can also be used to deposit silicon nitride films and to pattern the same by etching. The reactive gas for deposition may be composed of ammonia and silane for example, and the etchant gas may be NF₃, SF₆ or CF₃.

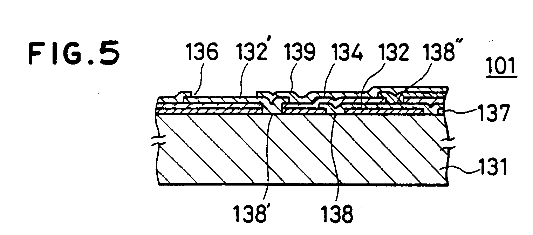

Referring to Fig.5, a fourth embodiment is illustrated. An insulating film 137 is formed on a substrate 131 and patterned with openings 138 and 138'. Over the insulating film 137 there is formed a superconducting film 132 followed by patterning thereof. A carbon film 134 is deposited over both the superconducting film 132 and the insulating film 137 and patterned by etching in the same way as explained in conjunction with Fig.3 to produce openings 138' and 138''. Another superconducting ceramic film 132' is deposited by sputtering onto the films already formed, and makes contact with the substrate 131 through the opening 138' and with the underlying superconducting film 132 through the opening 138''. Finally, another carbon film 139 (or other passivation film) is overlaid and patterned to produce a bonding pad 136 for the superconducting wiring 132'. Although not shown in Fig 5, the superconducting film is enclosed by carbon films at its upper and lower surfaces to prevent contact with other insulating film.

Carbon employed for the devices in accordance with the present invention may contain hydrogen and/or halogens at not higher than 25 atom%, or trivalent or pentavalent impurity at not higher than 5 atom%, or nitrogen at N/C ≦ 0.05.

Although, in the above description, a semiconductor substrate provided with active devices therein is utilized, a ceramic substrate coated with a non-oxide film such as of 5 x 10⁻⁹m to 5 x 10⁻⁷m (50 to 5000 Å) thick silicon nitride on its upper surface may instead be used. For example a YSZ (yttrium stabilized zircon) substrate may be used which has a coefficient of thermal expansion substantially the same as that of the ceramic.

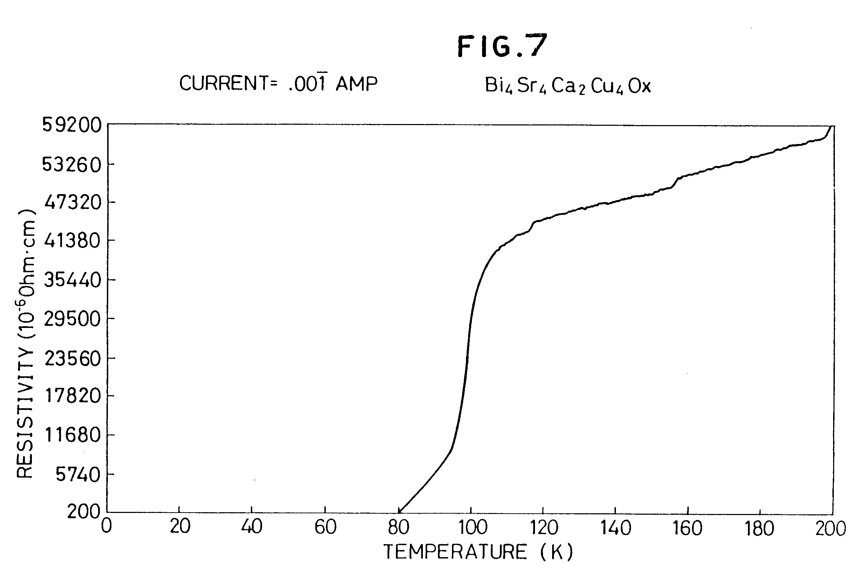

Superconducting ceramics for use in accordance with the present invention also may be prepared in accordance with the stoichiometric formulae (A₁₋ₓBₓ)_{y}Cu_{z}0_{w}, where A is one or more elements of Group IIIa of the Japanese Periodic Table, e.g. the rare earth elements, B is one or more elements of Group IIa of the Japanese Periodic Table, e.g. the alkaline earth metals including beryllium and magnesium, and 0<x<1; y=2.0-4.0, preferably 2.5-3.5; z=1.0-4.0, preferably 1.5-3.5; and w=4.0-10.0, preferably 6.0-8.0. One example is YBa₂Cu₃0₆₋₈. Also, superconducting ceramics for use in accordance with the present invention may be prepared in accordance with the stoichiometric formulae (A₁₋ₓBₓ)_{y}Cu_{z}0_{w}, where A is one or more elements of Group Vb of the Japanese Periodic Table such as Bi, Sb and As, B is one or more elements of Group IIa of the Japanese Periodic Table, e.g. the alkaline earth metals including beryllium and magnesium, and 0.3 ≦ x < 1; y=2.0-4.0, preferably 2.5-3.5; z=1.0-4.0, preferably 1.5-3.5; and w=4.0-10.0, preferably 6.0-8.0. Examples of this general formula are BiSrCaCuCu₂0ₓ and Bi₄Sr₃Ca₃Cu₄0ₓ. Tc onset and Tco for ceramic samples confirmed consistent with the formula Bi₄Sr_{y}Ca₃Cu₄0ₓ (y around 1.5) were measured to be 40-60°K, which is not particularly high. Relatively high critical temperatures were obtained with samples conforming to the stoichiometric formulae Bi₄Sr₄Ca₂Cu₄0ₓ and Bi₂Sr₃Ca₂Cu₂0ₓ. Figs.7 and 8 are graphical diagrams showing the relationship between the resistivity and the temperature for both samples. The number W designating the oxygen proportion is 6-10, e.g. around 8.1.

While a description has been made for several embodiments, the scope of the present invention is as determined by the appended claims and is not limited by the particular examples.

## Claims

1. An electric circuit comprising a thin film oxide superconductor (3;5;133;132) formed on a substrate (1;131), characterized in that the thin film oxide superconductor comprises electrical circuit conductors formed of a superconductive oxide material, and an electrically insulating isolation layer (2;6;6';134) of non-oxide material which does not interact or mix during firing with the superconductive oxide material is provided above and/or below the superconductive conductors covering and isolating the superconductive oxide material of the conductors from adjacent structure(s) of the circuit.

2. A circuit as claimed in claim 1, wherein said isolation layer (2;6,6') comprises a nitride material.

3. A circuit as claimed in claim 2, wherein said nitride material comprises silicon nitride, aluminium nitride or titanium nitride.

4. A circuit as claimed in claim 1, wherein said isolation layer (2;6,6') comprises a carbide material.

5. A circuit as claimed in claim 4, wherein said carbide material comprises silicon carbide or titanium carbide.

6. A circuit as claimed in claim 1, wherein said isolation layer (134) comprises a carbonaceous material.

7. A circuit as claimed in claim 6, wherein said carbonaceous material is a diamond-like carbon.

8. A circuit as claimed in any one of the preceding claims wherein said substrate (1;131) is a semiconductor substrate, with one or more semiconductor devices (20) being formed in or on said semiconductor substrate (1), and wherein said electrical circuit conductors (5) formed of a superconductive oxide material are connected to said one or more semiconductor devices (20).

9. A circuit as claimed in claim 8, wherein said one or more semiconductor devices (20) includes at least one IGFET and/or at least one bipolar transistor.

10. A circuit as claimed in claim 8 or 9, wherein said electrically insulating isolation layer of non-oxide material (2;6) is provided between the semiconductor substrate (1) and said electrical circuit conductors (3;5) formed of a superconductive oxide material.

11. A circuit as claimed in claim 10, wherein said electrical circuit conductors formed of a superconductive oxide material extend into electrical contact with terminal portions of said one or more semiconductor devices through openings (8) formed in said electrically insulating isolation layer (2) of non-oxide material.

12. A circuit as claimed in any one of claims 8 to 11 wherein said semiconductor substrate (1;131) is a silicon semiconductor substrate.

13. A circuit as claimed in any one of claims 8 to 11, wherein said semiconductor substrate (1;131) is a gallium arsenide semiconductor substrate.

14. A circuit as claimed in any one of claims 1 to 7, wherein said substrate (1;131) comprises a ceramic substrate.

15. A circuit as claimed in any one of the preceding claims, wherein said superconductive oxide material comprises a superconductive copper oxide ceramic material.

16. A circuit as claimed in claim 15, wherein said superconductive copper oxide ceramic material comprises a material conforming to the general formula:
(A₁₋ₓBₓ)_{y}Cu_{z}O_{w}
where A represents one or more elements selected from Group IIIa of the Japanese notation of the Periodic Table, B represents one or more elements selected from Group IIa of the Japanese notation of the Periodic Table, and O<x<1; y=2.0-4.0; z=1.0-4.0 and w=4.0-10.0.

17. A circuit as claimed in claim 16, wherein said superconductive copper oxide ceramic material comprises YBa₂Cu₃O₆₋₈.

18. A circuit as claimed in claim 15, wherein said superconductive copper oxide ceramic material comprises a material conforming to the general formula:
(A₁₋ₓBₓ)_{y}Cu_{z}O_{w}
where A represents one or more elements selected from Group Vb of the Japanese notation of the Periodic Table, B represents one or more elements selected from Group IIa of the Japanese notation of the Periodic Table, and 0.3≦ x <1.0; y=2.0-4.0; z=1.0-4.0 and w=4.0-10.0.

19. A circuit as claimed in claim 18, wherein A represents Bismuth.

## Patentansprüche

1. Elektrische Schaltung mit einem auf einem Substrat (1; 131) ausgebildeten Dünnfilm aus einem Oxidsupraleiter (3; 5; 133; 132), **dadurch gekennzeichnet**, daß der dünne Film aus dem Oxidsupraleiter aus einem supraleitenden Oxidmaterial hergestellte elektrische Schaltkreisleiter aufweist, und eine elektrisch isolierende Isolierschicht (2; 6; 6'; 134) aus nichtoxidischem Material, das während eines Brennvorgangs nicht mit dem supraleitenden Oxidmaterial wechselwirkt oder sich mit diesem Vermischt, über und/oder unter den supraleitenden Leitern angebracht ist, die das supraleitende Oxidmaterial der Leiter gegen eine benachbarte Struktur (benachbarte Strukturen) der Schaltung abdeckt und isoliert.

2. Schaltung nach Anspruch 1, bei der die Isolierschicht (2; 6, 6') ein Nitridmaterial aufweist.

3. Schaltung nach Anspruch 2, bei der das Nitridmaterial Siliziumnitrid, Aluminiumnitrid oder Titannitrid ist.

4. Schaltung nach Anspruch 1, bei der die Isolierschicht (2; 6, 6') ein Carbidmaterial aufweist.

5. Schaltung nach Anspruch 4, bei der das Carbidmaterial Siliziumcarbid oder Titancarbid ist.

6. Schaltung nach Anspruch 1, bei der die Isolierschicht (134) ein kohlenstoffhaltiges Material aufweist.

7. Schaltung nach Anspruch 6, bei der das kohlenstoffhaltige Material diamantähnlicher Kohlenstoff ist.

8. Schaltung nach einem der vorstehenden Ansprüche, bei der das Substrat (1; 131) ein Halbleitersubstrat ist, wobei ein Halbleiterbauelement (20) oder mehrere in oder auf dem Halbleitersubstrat (1) ausgebildet ist bzw. sind, und bei der die aus einem supraleitenden Oxidmaterial hergestellten elektrischen Schaltkreisleiter (5) mit dem einen Halbleiterbauelement (20) oder den mehreren verbunden sind.

9. Schaltung nach Anspruch 8, bei der das eine Halbleiterbauelement (20) oder die mehreren mindestens einen IGFET und/oder mindestens einen Bipolartransistor enthält bzw. enthalten.

10. Schaltung nach Anspruch 8 oder Anspruch 9, bei der die elektrisch isolierende Isolierschicht aus nichtoxidischem Material (2; 6) zwischen dem Halbleitersubstrat (1) und dem aus einem supraleitenden Oxidmaterial hergestellten elektrischen Schaltkreisleiter (3; 5) vorhanden ist.

11. Schaltung nach Anspruch 10, bei der sich der aus einem supraleitenden Oxidmaterial hergestellte elektrische Schaltkreisleiter in elektrischem Kontakt mit Anschlußabschnitten mit dem einen Halbleiterbauelement oder den mehreren durch Öffnungen (8) hindurcherstreckt, die in der elektrische isolierenden Isolierschicht (2) aus nichtoxidischem Material ausgebildet sind.

12. Schaltung nach einem der Ansprüche 8 bis 11, bei der das Halbleitersubstrat (1; 131) ein Halbleitersubstrat aus Silizium ist.

13. Schaltung nach einem der Ansprüche 8 bis 11, bei der das Halbleitersubstrat (1; 131) ein Halbleitersubstrat aus Galliumarsenid ist.

14. Schaltung nach einem der Ansprüche 1 bis 7, bei der das Substrat (1; 131) ein Keramiksubstrat aufweist.

15. Schaltung nach einem der vorstehenden Ansprüche, bei der das supraleitende Oxidmaterial ein supraleitendes Kupferoxid-Keramikmaterial ist.

16. Schaltung nach Anspruch 15, bei der das supraleitende Kupferoxid-Keramikmaterial ein Material ist, das der folgenden allgemeinen Formel genügt:
(A₁₋ₓBₓ)_{y}Du_{z}O_{w},
wobei A ein Element oder mehrere, ausgewählt aus der Gruppe IIIa der japanischen Fassung des Periodensystems repräsentiert, B ein Element oder mehrere, ausgewählt aus der Gruppe IIa der japanischen Fassung des Periodensystems repräsentiert, und 0 < x < 1; y = 2,0 - 4,0; z = 1,0 - 4,0 und w = 4,0 - 10,0 sind.

17. Schaltung nach Anspruch 16, bei der das supraleitende Kupferoxid-Keramikmaterial YBa₂Cu₃O₆₋₈ ist.

18. Schaltung nach Anspruch 15, bei der das supraleitende Kupferoxid-Keramikmaterial ein Material ist, das der folgenden allgemeinen Formel genügt:
(A₁₋ₓBₓ)_{y}Du_{z}O_{w},
wobei A ein Element oder mehrere, ausgewählt aus der Gruppe Vb der japanischen Fassung des Periodensystems repräsentiert, B ein Element oder mehrere, ausgewählt aus der Gruppe IIa der japanischen Fassung des Periodensystems repräsentiert, und 0,3 ≦ x < 1,0; y = 2,0 - 4,0; z = 1,0 - 4,0 und w = 4,0 - 10,0 sind.

19. Schaltung nach Anspruch 18, bei der A Wismut repräsentiert.

## Revendications

1. Circuit électrique amélioré comprenant un film fin d'oxyde supraconducteur (3 ; 5 ; 133 ; 132) formé sur un substrat (1 ; 131), caractérisé en ce que le film fin d'oxyde supraconducteur comprend des conducteurs de circuit électrique formés d'une matière à base d'oxyde supraconductrice, et en ce qu'une couche d'isolation électriquement isolante (2 ; 6 ; 6' ; 134), composée d'une matière sans oxyde qui ne présente pas d'interaction ou ne se mélange pas pendant la cuisson avec la matière à base d'oxyde supraconductrice, est disposée au-dessus et/ou au-dessous des matières supraconductrices recouvrant et isolant la matière à base d'oxyde supraconductrice des conducteurs par rapport à la (aux) structure(s) adjacente(s) du circuit.

2. Circuit selon la revendication 1, dans lequel ladite couche d'isolation (2 ; 6, 6') comprend une matière à base de nitrure.

3. Circuit selon la revendication 2, dans lequel ladite matière à base de nitrure comprend le nitrure de silicium, le nitrure d'aluminium ou le nitrure de titane.

4. Circuit selon la revendication 1, dans lequel ladite couche d'isolation (2 ; 6, 6') comprend une matière à base de carbure.

5. Circuit selon la revendication 4, dans lequel ladite matière à base de carbure comprend le carbure de silicium ou le carbure de titane.

6. Circuit selon la revendication 1, dans lequel ladite couche d'isolation (134) comprend une matière carbonée.

7. Circuit selon la revendication 6, dans lequel ladite matière carbonée est du carbone analogue au diamant.

8. Circuit selon l'une quelconque des revendications précédentes, dans lequel ledit substrat (1 ; 131) est un substrat semi-conducteur, avec un ou plusieurs dispositifs à semi-conducteurs (20) formés dans ledit substrat semi-conducteur (1) ou sur celui-ci, et dans lequel lesdits conducteurs de circuit électrique (5) constitués par une matière à base d'oxyde supraconductrice sont reliés sur ledit ou lesdits dispositifs à semi-conducteurs (20).

9. Circuit selon la revendication 8, dans lequel ledit ou lesdits dispositifs à semi-conducteurs (20) incluent au moins un IGFET et/ou au moins un transistor bipolaire.

10. Circuit selon la revendication 8 ou la revendication 9, dans lequel ladite couche d'isolation électriquement isolante en matière sans oxyde (2 ; 6) est prévue entre le substrat semi-conducteur (1) et lesdits conducteurs de circuit électrique (3 ; 5) constitués par une matière à base d'oxyde supraconductrice.

11. Circuit selon la revendication 10, dans lequel lesdits conducteurs de circuit électrique constitués par une matière à base d'oxyde supraconductrice s'étendent sous forme de contact électrique avec des parties en bornes dudit ou desdits dispositifs à semi-conducteur à travers des orifices (8) formés dans ladite couche d'isolation électriquement isolante (2) en matière sans oxyde.

12. Circuit selon l'une quelconque des revendications 8 à 11, dans lequel ledit substrat semi-conducteur (1 ; 131) est un substrat semi-conducteur en silicium.

13. Circuit selon l'une quelconque des revendications 8 à 11, dans lequel ledit substrat semi-conducteur (1 ; 131) est un substrat semi-conducteur en arséniure de gallium.

14. Circuit selon l'une quelconque des revendications 1 à 7, dans lequel ledit substrat (1 ; 131) comprend un substrat en céramique.

15. Circuit selon l'une quelconque des revendications précédentes, dans lequel ladite matière à base d'oxyde supraconductrice comprend une matière à base de céramique d'oxyde de cuivre supraconductrice.

16. Circuit selon la revendication 15, dans lequel ladite matière à base de céramique d'oxyde de cuivre supraconductrice comprend une matière conforme à la formule générale :
(A₁₋ₓBₓ)_{y}Cu_{z}O_{w}
où A représente l'un ou plusieurs des éléments du groupe IIIa de la table périodique japonaise, où B représente l'un ou plusieurs des éléments du groupe IIa de la table périodique japonaise, et où 0 < x < 1 ; y = 2,0 - 4,0 ; z = 1,0 - 4,0 ; et w = 4,0 - 10,0.

17. Circuit selon la revendication 16, dans lequel ladite matière à base de céramique d'oxyde de cuivre supraconductrice comprend le YBa₂Cu₃O₆₋₈.

18. Circuit selon la revendication 15, dans lequel ladite matière à base de céramique d'oxyde de cuivre supraconductrice comprend une matière conforme à la formule générale:
(A₁₋ₓBₓ)_{y}Cu_{z}O_{w}
où A représente l'un ou plusieurs des éléments du groupe Vb de la table périodique japonaise, où B représente l'un ou plusieurs des éléments du groupe IIa de la table périodique japonaise, et où 0,3 ≦ x < 1,0 ; y = 2,0 - 4,0 ; z = 1,0 - 4,0 ; et w = 4,0 - 10,0.

19. Circuit selon la revendication 18, dans lequel A représente le bismuth.
